# EUROPEAN PATENT APPLICATION

(11) **EP 3 296 625 A1**
(43) Date of publication of application: **21.03.2018**
(21) Application number: 15891429.1
(22) Date of filing: 18.05.2015
(51) Int. Cl.: F21V 7/22

(54) **LED REFLECTIVE STRUCTURE**

(30) Priority: 08.05.2015 CN 201510233762
(71) Applicant: Li, Feng, Shenzhen, Guangdong 518000 (CN)
(72) Inventor: Li, Feng, Shenzhen, Guangdong 518000 (CN)
(74) Representative: Cabinet Chaillot
(86) International application number: PCT/CN2015/000332
(87) International publication number: WO 2016/179721

(57) **Abstract**

A reflection structure for an LED lamp contains: a substrate (10) having an accommodation groove in which a plurality of cavities (11) are defined and configured to accommodate multiple light-emitting diode (LED) chips respectively. The substrate (10) also includes multiple partition ribs (12) fixed in the accommodation groove of the substrate (10) and configured to separate the plurality of cavities (11). Each of the multiple partition ribs (12) separates any two adjacent of the plurality of cavities (11). Thereby, light from said each LED chip is reflected by said each partition rib (12) and its radiation flux increases by way of a Nano-reflective material layer of said each partition rib (12), such that the substrate (10) of the reflection structure protects said LED chip and dissipates heat of said LED chip effectively.

## Description

### FIELD OF THE INVENTION

The present invention relates to a reflection structure for an LED lamp which protects multiple LED chips and dissipates heat of each LED chip effectively.

### BACKGROUND OF THE INVENTION

A conventional LED chip contains light-emitting diode (LED) which is a two-lead semiconductor light source. It is a p-n junction diode, which emits light when activated.

In application, multiple light-emitting diode (LED) chips are die bonded on a printed circuit board (PCB) of an LED illumination device and are packaged. Alternatively, a single light-emitting diode (LED) chip is mounted and packaged on a support, and the support is fixed on the PCB, wherein a reflective lens is arranged on the LED illumination device so as to reflect and adjust the light from the LED chip.

The light from the LED chip impacts fluorescent powder so that the fluorescent powder emits fluorescence beams, but light loss of the fluorescence beams occurs.

Furthermore, lights between any two of the multiple LED chips offset with each other and reduce because of photon impact.

The present invention has arisen to mitigate and/or obviate the afore-described disadvantages.

### SUMMARY OF THE INVENTION

The primary objective of the present invention is to provide a reflection structure for an LED lamp which protects multiple LED chips and dissipates heat of each LED chip effectively.

To obtain above-mentioned objective, a reflection structure for an LED lamp provided by the present invention contains: a substrate having an accommodation groove in which a plurality of cavities are defined and configured to accommodate multiple light-emitting diode (LED) chips respectively.

The substrate also includes multiple partition ribs fixed in the accommodation groove of the substrate and configured to separate the plurality of cavities, wherein each of the multiple partition ribs separates any two adjacent of the plurality of cavities.

Preferably, four peripheral walls of each of the plurality of cavities are defined by a side wall of the accommodation groove of the substrate and three of the multiple partition ribs or by four of the multiple partition ribs.

Preferably, an angle between each of the four peripheral walls of said each cavity and a top of said each cavity is 45 degrees.

Preferably, a cross section of said each partition rib is in a triangle shape.

Preferably, a cross section of said each partition rib is in an isosceles trapezoid shape.

Preferably, said each partition rib has a central support made of carbon fibers and has a reinforcement covering made of metal material. Thereby, said each partition rib is reinforced so as to protect each of the LED chips accommodated in each of the plurality cavities.

Preferably, said each partition rib further has a Nano-reflective material layer coated on the reinforcement covering so as to increase radiation flux of light of said each LED chip accommodated in said each cavity.

Accordingly, light from said each LED chip is reflected by said each partition rib and its radiation flux increases by way of a Nano-reflective material layer of said each partition rib, such that the substrate of the reflection structure protects said LED chip and dissipates heat of said LED chip effectively.

### BRIEF DESCRIPTION OF THE DRAWINGS

FIG. 1 is a perspective view showing the assembly of a reflection structure for an LED lamp according to a first embodiment of the present invention.
FIG. 2 is a cross sectional view showing the assembly of a part of the reflection structure for the LED lamp according to the first embodiment of the present invention.

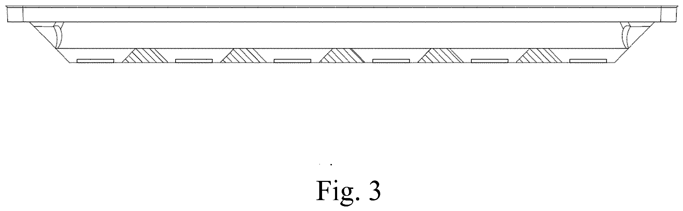

FIG. 3 is a cross sectional view showing the assembly of a part of a reflection structure for an LED lamp according to a second embodiment of the present invention.

### DETAILED DESCRIPTION OF THE PREFERRED EMBODIMENTS

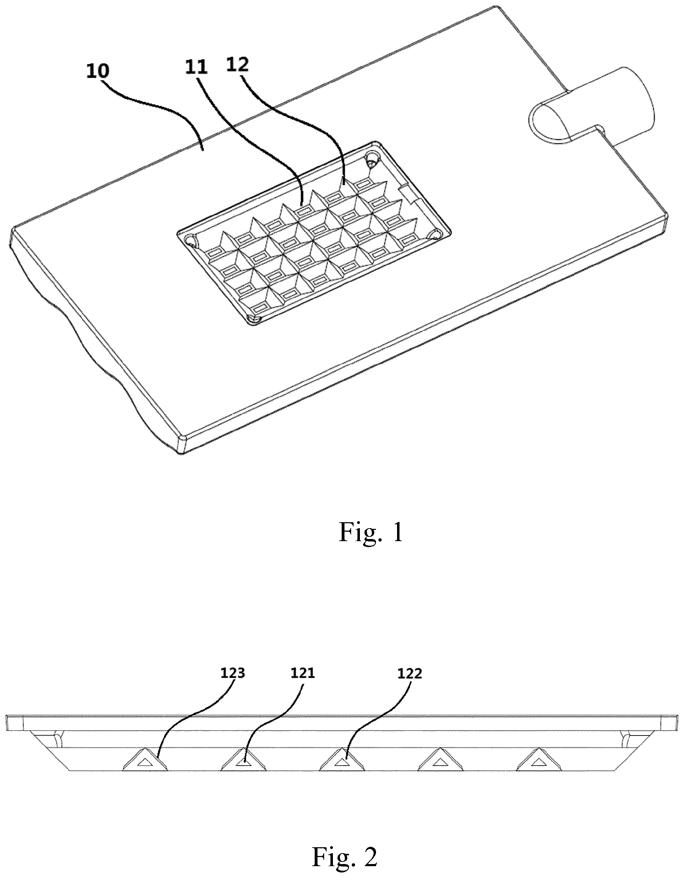

With reference to FIG. 1, a reflection structure for a light-emitting diode (LED) lamp according to a first embodiment of the present invention comprises: a substrate 10 having an accommodation groove in which a plurality of cavities 11 are defined and configured to accommodate multiple light-emitting diode (LED) chips (not shown) respectively. The substrate 10 also includes multiple partition ribs 12 fixed in the accommodation groove thereof and configured to separate the plurality of cavities 11, for example, each of the multiple partition ribs 12 separates any two adjacent of the plurality of cavities 11.

The substrate 10 is in a rectangle shape or in a circle shape, and the plurality of cavities 11 are defined in a rectangular array in the substrate 10. Alternatively, the plurality of cavities 11 are defined in a circular array in the substrate 10.

Referring to FIG. 2, said each partition rib 12 has a central support 121 made of carbon fibers and has a reinforcement covering 122 made of metal material. Thereby, said each partition rib 12 is reinforced so as to protect each of the LED chips accommodated in each of the plurality cavities 11. Preferably, the central support 121 is made of carbon fibers and the reinforcement covering 122 is made of metal material, hence a heat dissipation of the substrate 10 enhances.

In addition, the multiple partition ribs 12 support other components mounted on the substrate 10.

Said each partition rib 12 further has a Nano-reflective material layer 123 coated on the reinforcement covering 122 so as to increase radiation flux of light of said each LED chip accommodated in said each cavity 11.

Four peripheral walls of said each cavity 11 are defined by a side wall of the accommodation groove of the substrate 10 and three of the multiple partition ribs 12 or by four of the multiple partition ribs 12, wherein an angle between each of the four peripheral walls of said each cavity 11 and a top of said each cavity 11 is 45 degrees, and a cross section of said each partition rib 12 is in a triangle shape. Preferably, the cross section of said each partition rib 12 is in an equilateral triangle shape so as to support and protect said each Led chip firmly.

As shown in FIG. 2, in a second embodiment, a cross section of said each partition rib 12 is in a trapezoid shape. Preferably, the cross section of said each partition rib 12 is in an isosceles trapezoid shape.

Thereby, the light from said each LED chip is reflected by said each partition rib and its radiation flux increases by way of the Nano-reflective material layer, and said each partition rib protects said each LED chip, hence the substrate of the reflection structure protects said LED chip and dissipates heat of said LED chip effectively.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. A reflection structure for an LED lamp comprising:
a substrate (10) having an accommodation groove in which a plurality of cavities (11) are defined and configured to accommodate multiple light-emitting diode (LED) chips respectively,
the substrate (10) also including multiple partition ribs (12) fixed in the accommodation groove of the substrate (10) and configured to separate the plurality of cavities (11);
**characterized in that**
each of the multiple partition ribs (12) separates any two adjacent of the plurality of cavities (11).

2. The reflection structure as claimed in claim 1, **characterized in that** said each partition rib (12) has a central support (121) made of carbon fibers and has a reinforcement covering (122) made of metal material.

3. The reflection structure as claimed in claim 2, **characterized in that** four peripheral walls of each of the plurality of cavities (11) are defined by a side wall of the accommodation groove of the substrate (10) and three of the multiple partition ribs (12) or by four of the multiple partition ribs (12).

4. The reflection structure as claimed in claim 3, **characterized in that** an angle between each of the four peripheral walls of said each cavity (11) and a top of said each cavity (11) is 45 degrees.

5. The reflection structure as claimed in claim 4, **characterized in that** a cross section of said each partition rib (12) is in a triangle shape.

6. The reflection structure as claimed in claim 4, **characterized in that** a cross section of said each partition rib (12) is in an isosceles trapezoid shape.
